Europäisches Patentamt

European Patent Office

Office européen des brevets

(11) Publication number: **0 201 986**
A2

# EUROPEAN PATENT APPLICATION

(21) Application number: **86301593.9**

(22) Date of filing: **06.03.86**

(51) Int. Cl.⁴: **H 04 B 1/10**
**H 03 D 7/12**

(30) Priority: **10.04.85 JP 74333/85**

(43) Date of publication of application:
**20.11.86 Bulletin 86/47**

(84) Designated Contracting States:
**AT BE CH DE FR GB IT LI NL SE**

(71) Applicant: **UNIDEN CORPORATION**
**7-4 Onitaka 4 chome**
**Ichikawa-shi Chiba-ken(JP)**

(72) Inventor: **Hachiga, Hitoshi**
**6-11-9 Aobadai Ichihara-shi**
**Chiba-ken(JP)**

(74) Representative: **Evans, David Charles et al,**
**F.J. CLEVELAND & COMPANY 40-43, Chancery Lane**
**London, WC2A 1JQ(GB)**

(54) Intermodulation suppressing circuit.

(57) An intermodulation suppressing circuit is to be connected in the input stage of a frequency processing circuit (1a, 1b) using non-linear elements. It is designed to allow the passage therethrough of beat wave signals (fb) produced as a result of intermodulation of the wanted signal (fl) with an interference signal (fn) whose frequency is different from the frequency of the wanted signal, thereby reducing the intermodulation effect on the frequency processing circuit.

EP 0 201 986 A2

0201986

## INTERMODULATION SUPPRESSING CIRCUIT

The present invention relates to an intermodulation suppressing circuit for use in a frequency-modulation or frequency-conversion stage using non-linear elements, high-frequency amplification stage having non-linearity for input signals of relatively large amplitude or any other stage handling signals of relatively high frequency.

One of the problems which should be taken into consideration in designing high-frequency processing circuits as used in radio communication sets is intermodulation interference.

As is well known, this adverse effect is caused by the modulation of a plurality of signal components of different frequencies by each other, as a result of which countless beat waves are produced that have frequencies equal to the sums and differences of the integral multiples of those of the original signal components. The amplitude of a beat wave signal decreases with the increase of the order of the beat wave signal.

Among these beat wave signals there are some which have frequencies far apart from the frequency of the signal which is supposed to be treated in the signal processing stage (hereinafter referred to as "wanted signal"). Assume that an intermodulation is caused between a wanted wave signal of 900 MHz and an interference wave signal of 900.1 MHz, and that as a result a beat wave signal of as low frequency as 100 KHz appears.

Such a low-frequency beat wave signal can be easily eliminated by a subsequent bandpass filter, thus causing no problem so far as the low-frequency beat wave signal is concerned. However, it should be noted that the trouble caused by such a low-frequency beat wave signal is intermodulation or crossmodulation of the beat wave signal and the wanted signal by each other. Assume that a beat wave signal is at 100 KHz which is far remote from the frequency of the wanted signal (900 MHz), and is of relatively large amplitude. Then, it is still possible that the wanted wave signal of 900 MHz will be subjected to crossmodulation with the low-frequency beat wave signal.

Once such crossmodulation has resulted, crossmodulated frequency components can pass through subsequent bandpass filters, which are blind to such undesired components.

Still disadvantageously, additional intermodulations are apt to result between these undesired component signals and other beat wave signals or the wanted signal, causing the appearance of undesired signals hardly distinguishable from the wanted one.

These adverse effects are repeated in a plurality of frequency conversion and amplification stages so that undesired signals after being amplified, finally appear at the output terminal of the apparatus as noise components.

Generally speaking, a fairly large number of undesired frequency components are caused not only by simple intermodulation but also by other complicated interference factors, and multiply the adverse effect.

Up to now due attention has not been given to the mechanism by which such undesired frequency components arise, and attempts have merely been made to suppress the appearance of undesired frequency components at the output terminal of a frequency signal processing stage by eliminating different intermodulations at their sources, such as by trying to reduce the generation of beat wave signals to the minimum possible by expanding the dynamic range of linearity of high-frequency amplification stages and other linear circuits. As for modulation stages, frequency conversion stages and other non-linear circuits, their characteristics cannot be designed so as to suppress intermodulation, and therefore efforts have been directed to improvement of the sensitivity of bandpass filters and tuning circuits provided ahead of such non-linear circuits to the point that little interference signal is allowed to pass to the input terminals of these non-linear circuits.

As described above, linear and non-linear circuits rely on different ways of suppressing intermodulation, improvement of linearity being relied on as regards the former and improvement of the quality factor of prefilters or tuner circuits being relied on as regards the latter. The common point between these two ways is that both aim to minimize the probability of causing intermodulation.

As a matter of course there are limits to improvement of linearity or quality factor in designing and fabricating receivers and other circuits. From the economical point of view, it is, in fact, difficult to select and use only circuit elements of good linearity or good quality factor, and from the designing point of view, it is also difficult to select the dynamic range of the circuit only from the angle of minimizing intermodulation. These countermeasures are very often limited because of inevitable increase of cost and of difficulty in meeting requirements in high-frequency circuit design.

Even if a frequency converter is equipped with a pre-bandpass filter of good selectivity of frequency, the filter will be useless in suppressing intermodulation between the wanted wave signal and beat wave signals, which are caused by mixing the wanted wave signal and any interference wave signal which finds its way directly into the frequency conversion stage without passing through the bandpass filter. Intermodulation in linear circuits cannot be completely avoided by improvement of their linearity. Even if the linearity of the linear circuits could be improved to a satisfactory degree, a non-linear domain would still remain and therefore, if an interference wave should have an amplitude large enough to reach this non-linear domain, intermodulation would still result.

Conventional attempts to suppress intermodulation have been directed to prevention of generation of beat wave signals, and therefore the remedies are useless in suppressing intermodulation once beat wave signals have been produced.

The object of the present invention is to provide an improved circuit for suppressing intermodulation interference both in linear and non-linear circuits at the respective stages on the fact that the cause for noise signals, which are caused by the primitive intermodulation of the original signal, often resides in crossmodulation of the wanted signal with beat wave signals, and also in mutual intermodulation of the wanted signal with the beat wave signals. Furthermore, instead of trying to eliminate the causes for the adverse effects of intermodulation and crossmodulation, the inventor aimed at providing each stage with means for suppressing the influence of intermodulation and crossmodulation.

To attain the object described above, the intermodulation suppressing circuit according to the present invention is composed of a shunt circuit which is to be connected across a linear or non-linear frequency processing stage, whereby a beat wave signal caused by intermodulation of the wanted signal with an interference signal may be shunted to the ground. Thus, the beat wave signals which otherwise would enter and cause an adverse effect in the frequency processing stage, can be shut out or reduced in amplitude to the point that little or no adverse effect is caused in the frequency processing .pa stage.

Other objects and advantages of the present invention will be best understood from the following description of preferred embodiments which are shown in the accompanying drawings, in which:

Figures 1(A) and 1(B) diagrammatically show intermodulation suppressing circuits according to the present invention applied to non-linear and linear frequency processing stages, respectively;

Figure 2 shows a general circuit diagram of a frequency processing system in which intermodulation suppressing circuits according to the present invention may be used in different portions of the system;

Figures 3(A), 3(B) and 3(C) shows different applications of an intermodulation circuit according to the present invention;

Figures 4(A) and 4(B) are still different applications of an intermodulation circuit according to the present invention; and

Figure 5 is a graph representing the resonance characteristics of a series resonance circuit used as a beat wave signal shunting circuit according to the present invention.

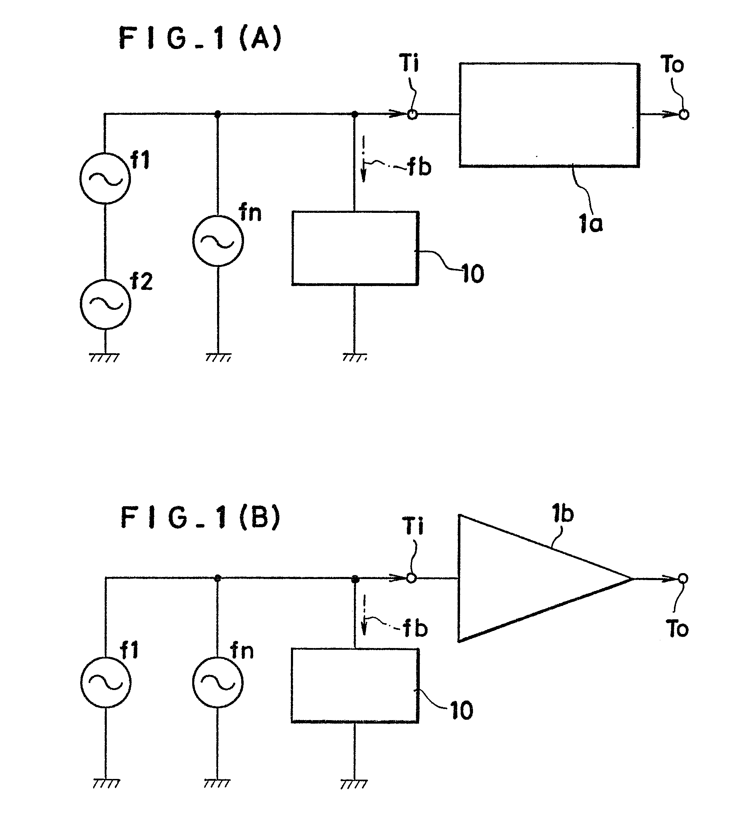

Figure 1(A) shows a frequency conversion stage 1a equipped with means for suppressing intermodulation according to the present invention whereas Figure 1(B) shows a high-frequency amplification stage lb equipped
with means for suppressing intermodulation according to
the present invention.

As is well known, the frequency conversion circuit
is intrinsically non-linear. Contrary to this, the high-
frequency amplifier is desired to have strict linearity
over its full range of operation, but, in fact, it is
somewhat non-linear.

As shown in Figure 1(A), a wanted signal of
frequency f1 and a local oscillation signal of frequency
f2 are applied to the input terminal Ti of the non-linear
frequency conversion stage la. Then, the frequency
conversion stage is desired to provide at the output
terminal To thereof a signal whose frequency is equal to
the difference (or sum) of the frequency of the wanted
signal f1 and that of the local oscillation signal f2.

However, if an interference signal of frequency fn
should happen to invade the stage la through the input
terminal Ti, the wanted signal f1 or the local osicllation
signal f2 will be subjected to intermodulation with the
interference signal, thus producing a plurality of beat
wave signals fb. For the sake of convenience in
explanation only the beat wave signal of the first order
is taken into consideration. Then, the beat wave signal
fb can be given by one of the following equations 1 and 2:

$$fb = f1 \pm fn \qquad \ldots\ldots \qquad (1)$$
$$fb = f2 \pm fn \qquad \ldots\ldots \qquad (2)$$

Generally, the frequency of the beat wave signal is far
apart from the original signals f1 and f2.

However, if the beat wave signal fb should have an
increased amplitude, the original signals f1 and f2 would
be subjected to intermodulation with the beat wave signal
fb. At least this sort of intermodulation should be taken
into consideration in designing the circuitry.

What is worse is that such beat wave signal fb may cause parasitic intermodulation, and the resultant beat wave signals may cause crossmodulation and intermodulation.

A beat wave signal shunting circuit 10 is connected across the input terminal Ti of the frequency conversion stage 1a according to the present invention so that the beat wave signal fb may be shunted to ground. With this arrangement even if a beat wave signal fb is produced, it will be shunted to ground without invading the non-linear stage 1a.

As a result the beat signal is eliminated, or at least its amplitude is reduced to the point that little or no crossmodulation and intermodulation will be caused in the frequency modulation stage.

The shunt circuit 10 has no effect on the wanted signal fl and the local oscillation signal, which are allowed to pass to the non-linear stage 1a.

This is, for example, the case with a linear stage such as a high-frequency amplification stage 1b equipped with a similar shunt circuit as shown in Figure 1(B).

As is well known, a linear circuit such as used in a radio communication set is designed to pass signal fl with the least possible distortion, but if an interference signal fn should have an amplitude so large as to extend beyond the linear operating range of the linear circuit, beat wave components fb as represented by equations 1 and 2 will appear, thereby subjecting the wanted signal fl to crossmodulation, or sometimes causing parasitic intermodulation.

By applying the present invention to the linear circuit, specifically by connecting a beat wave signal shunting circuit 10 across the input terminal Ti of the linear circuit, no beat wave signal can invade the linear circuit, and only the wanted signal is allowed to enter so that it is processed appropriately and output at the output terminal To of the linear circuit.

Thus, the present invention enables elimination of crossmodulation, intermodulation and parasitic intermodulation due to beat wave signals caused by primitive intermodulation. This is different from the conventional idea of attempting to eliminate the cause of beat wave signals at their sources.

A beat eliminator circuit according to the present invention may be used for instance in a radio receiver at places where beat wave signals are apt to appear.

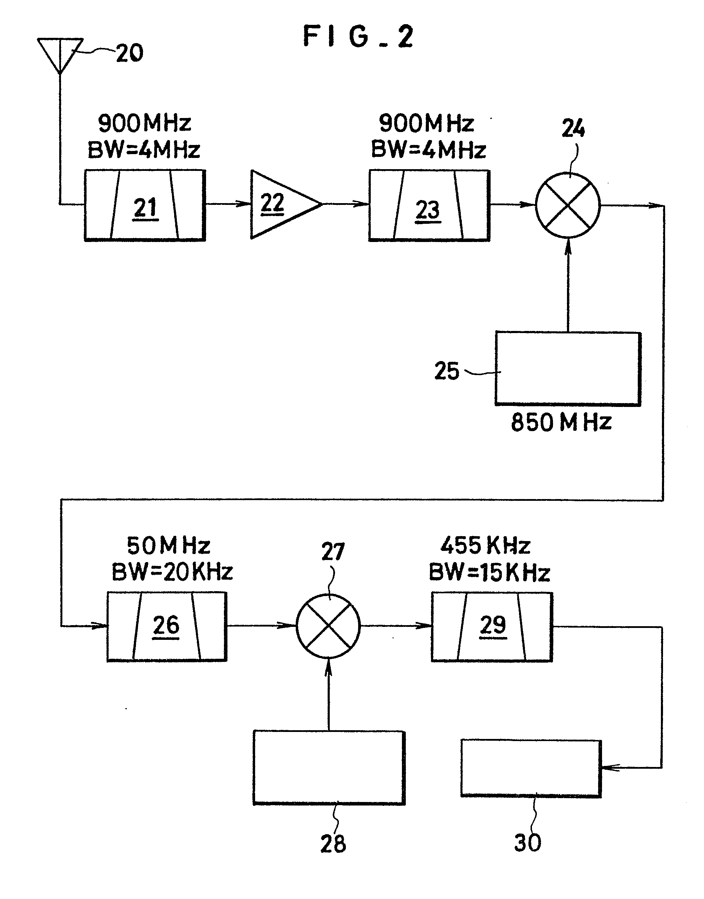

Figure 2 shows the general structure of a radio receiver working at a frequency of 900 MHz. A high-frequency signal is received by an antenna 20 and passed through a first bandpass filter 21 whose transmission band is as wide as 2 MHz on either side of the center frequency of 900 MHz. After passing through the first bandpass filter 21, the signal is amplified by a high-frequency amplifier stage 22, and then the amplified signal is sent to a second bandpass filter 23 where the transmission band is also as wide as 2 MHz on either side of the center frequency of 900 MHz. After passing through the second bandpass filter 23 the signal is applied to a first mixer or frequency conversion stage 24.

A first local oscillation circuit 25 is associated with the first mixer 24 for supplying it with a local oscillation signal, which can be varied stepwise by an interchannel frequency difference about the center frequency of 850 MHz. Thus, a signal of as low frequency as 50 MHz appears at the output terminal of the first mixer 24.

This signal of reduced frequency passes through a third bandpass filter 26 whose transmission band is as wide as 20 KHz about the center frequency of 50 MHz. The filtered signal is directed to a second mixer 27, in which it is mixed with a local oscillation signal of a given fixed frequency supplied by an associated second local oscillation circuit 28. As a result, the frequency of the signal is reduced to the ordinary intermediate frequency of 455 KHz. The resultant signal passes through a fourth bandpass filter 29 whose transmission band is as narrow as 15 KHz about the center frequency of 455 KHz, and then the filtered signal is applied to a detection stage 30.

Thereafter the signal is directed to an ordinary low-frequency signal processing circuit (not shown), and finally it is outputted in the form of an audio signal, for instance.

Assume that an input signal is subjected to intermodulation with an interference signal, for instance, at the input terminal of the high-frequency amplifier stage 22 with the result that the wanted signal is subjected to crossmodulation (amplitude modulation) or intermodulation with resultant parasitic signals. In this case the resultant wave signals would pass through the subsequent bandpass filter 23 quite easily, and then intermodulation and crossmodulation would be caused again in the subsequent first mixer 24. Some of the undesired signals thus caused would pass through the third narrow-bandpass filter 26 to appear as noise signals after being detected and amplified.

A beat signal eliminator according to the present invention may be advantageously applied for instance at two different places in the receiver system. Specifically, a beat signal eliminator may be applied to the high-frequency amplifier stage 22 as shown in Figure 1(B), and a beat signal eliminator may be applied to the first mixer stage 24 as shown in Figure 1(A).

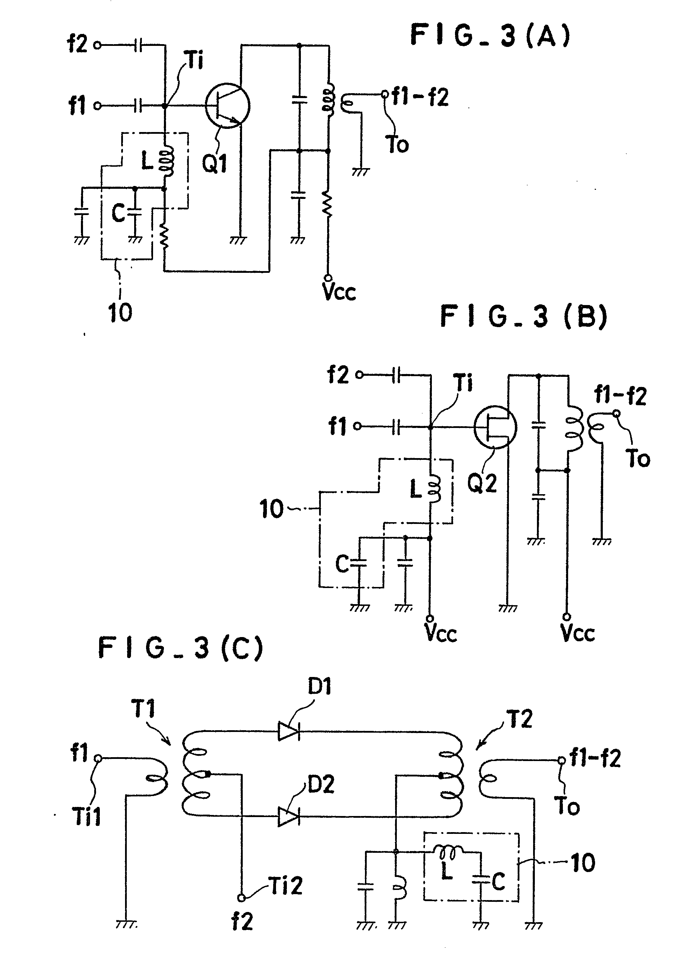

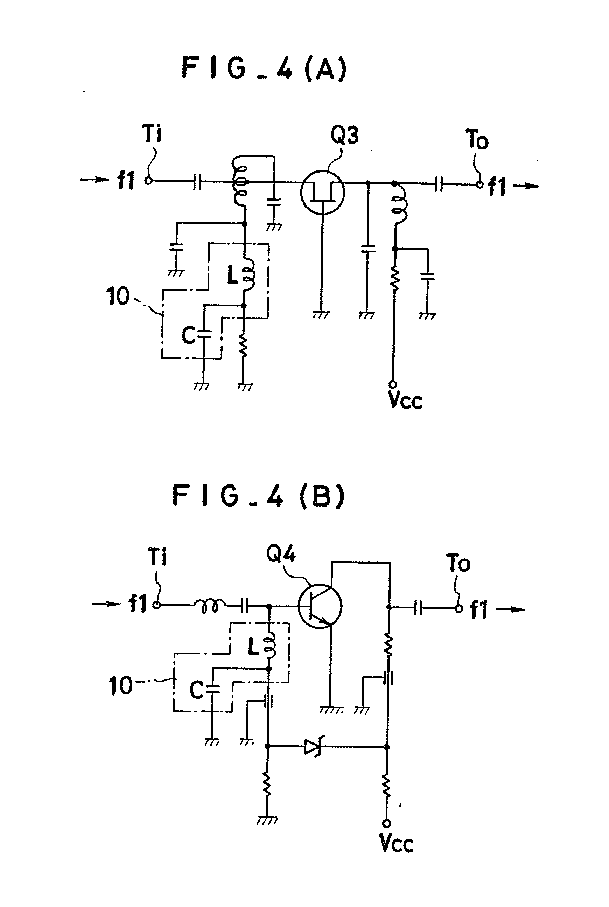

The beat signal eliminator is made in the form of a notch filter of relatively low "Q". Thus, it is constituted in the form of a series-resonance circuit of inductance L and capacitance C as shown in Figures 3 and 4.

Figure 3(A) shows how a beat signal eliminator is combined with a frequency conversion stage using a bipolar transistor Q1 as an active element for conversion of frequency, whereas Figure 3(B) shows how a beat signal eliminator is combined with a frequency conversion stage using a field-effect transistor Q2 as an active element for conversion of frequency. In these figures a series-connection of a capacitance C and an inductance L (encircled by broken lines) constitutes a beat signal eliminator according to the present invention, and the remaining part constitutes an ordinary frequency converter well known per se.

Although not shown, a frequency conversion stage using a duel-gate type field effect transistor may be equipped with a beat signal eliminator by connecting the series resonance circuit between one of the input terminals of the frequency conversion stage and ground, that is, across the active element of the frequency conversion stage. A beat signal eliminator according to the present invention may be applied to a passive type frequency converter using for instance a pair of diodes D1 and D2 as shown in Figure 3(C). A beat signal eliminator 10 is shown as being connected across a parallel connection of an inductance and capacitance joined to the center tap of the primary winding of an output coupling transformer T2, which is connected to the secondary winding of an input coupling transformer T1 through a pair of diodes D1 and D2.

Figure 4 shows different applications of a beat eliminator according to the present invention to different linear circuits. Specifically, Figure 4(A) shows a series resonance circuit 10 (encircled by a broken line) as being connected across a part of the input circuit of a high-frequency amplification stage using a field effect transistor Q3. Figure 4(B) shows a series resonance circuit 10 (enclosed by broken line) as being provided in the input circuit of a high-frequency amplification stage using a bipolar transistor Q4. These high-frequency amplification stages are well known, and therefore no detailed description is deemed to be necessary.

The resonance frequency and the quality factor Q of the series resonance circuit 10 may be determined in consideration of the frequency range of the beat wave signals to be eliminated and of the circuit constants of surrounding circuits.

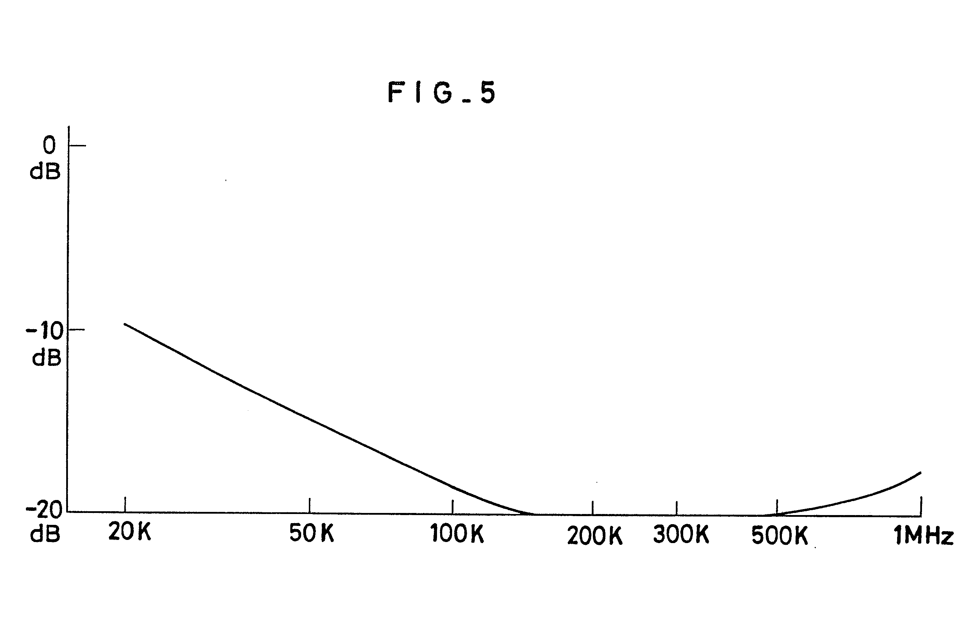

Figure 5 shows one example of the characteristics of a series resonance circuit appropriate for use in a high-frequency amplification stage 22 and a first mixer 24 of a 900 MHz band radio receiver (Figure 2). The center frequency of the series resonance circuit is about 250 KHz, and it shows a relatively broad resonance range.

The beat eliminator 10 is shown as being composed of a single inductance and a single capacitance. This simple structure is shown only for the sake of explanation. In actuality, the beat eliminator may be so constructed that it has a plurality of resonance ranges. Also, it may be equipped with a phase compensating means if it is made up of active elements.

As is apparent from the above, a beat wave signal suppressing circuit according to the present invention aims at elimination of beat wave signals appearing as a result of intermodulation rather than prevention of generation of beat wave signals, which has been hitherto attempted. Specifically, a beat wave signal suppressing circuit according to the present invention is designed to eliminate beat wave signals which would be caused by crossmodulation and parasitic intermodulation of harmonic components of the original signal appearing as a result of primitive intermodulation. These beat wave signals due to crossmodulation and parasitic intermodulation can hardly be suppressed with recourse to conventional means.

Also, it should be noted that conventional beat suppressing means may be used along with a beat eliminator according to the present invention. In such case, the former will function to eliminate the cause for generation of beat wave signals, whereas the latter will function to eliminate or reduce the beat wave signals produced ---- notwithstanding the effect of the former.

Generally a beat wave signal suppressing circuit according to the present invention may be made up in the form of a series resonance connection of a single inductance and a single capacitance. The resonance frequency of the filter may be determined to be appropriate for the purpose. For instance, if the frequencies of beat wave signals to be eliminated are of the order of several hundred kilohertz, far apart from the frequency range of the wanted signal (900 MHz), the center frequency is selected to be around several hundred kilohertz. In case that a single beat wave signal or a plurality of beat wave signals whose frequencies are fairly close to each other are to be eliminated, the figure of merit "Q" of the resonant circuit may be advantageously selected to be at a relatively high value. Otherwise, the figure of merit "Q" of the resonant circuit may be advantageously selected to be at as low a value as sufficient to allow the passage therethrough of a plurality of beat wave signals whose frequencies are fairly far apart from each other.

The incorporation of a beat eliminator in the input of the frequency processing circuit causes no adverse effect on the frequency processing circuit and, specifically does not cause reduction of the amplitude of the wanted signal. This is because the group of beat wave signals to be eliminated have frequencies far remote from that of the wanted signal, and the beat eliminator, which is designed to allow the passage of the beat signals of relatively high frequency, will not allow the passage of the wanted signal of relatively low frequency.

The beat eliminator according to the present invention is described herein as being applied to a frequency converter or to a high-frequency amplifier in a radio receiver. As a matter of course, however, it may be equally applied to a modulation stage or other frequency processing stages in a radio transmitter.

As may be understood from the above, a frequency processing circuit in which beat wave signals are liable to appear as a result of intermodulation can be modified according to the present invention to suppress beat wave signals caused by crossmodulation and parasitic intermodulation. Thus, the anti-intermodulation characteristics of the frequency processing circuit can be improved as required.

As already described, in case that an appreciable intermodulation effect appears, notwithstanding the provision of conventional anti-intermodulation means, and in case that parasitic intermodulation interference appears as a result of the primitive intermodulation effect, the resultant noise signals can be eliminated by providing a beat eliminator according to the present invention in addition to the conventional anti-intermodulation means.

Contrary to the above, in case of less strict requirements for anti-intermodulation, a frequency processing system may be equipped with a beat eliminator according to the present invention, thereby permitting the use of inexpensive circuit elements and units which would ordinarily be of unacceptable quality.

As a result, the production cost will be accordingly reduced. Also, advantageously the probability

0201986

of unacceptably low quality equipment being produced owing
to inclusion of circuit elements of poor quality will be
reduced thanks to the elimination of noise signals caused
thereby.

Claims:

1.    An intermodulation suppressing circuit for use in a radio receiver comprising a beat wave signal shunting circuit (10) to be connected in the input stage of a frequency processing circuit (1a, 1b) using non-linear circuit elements, said shunting circuit (10) being designed to allow the passage of beat wave signals (fb) appearing as a result of intermodulation of the wanted signal (fl) with an interference wave signal (fn) whose frequency is far apart from the frequency of the wanted signal.

2.    An intermodulation suppressing circuit according to claim 1 wherein said frequency processing circuit (1a, 1b) is a frequency conversion stage of said radio receiver.

3.    An intermodulation suppressing circuit according to claim 1 wherein said frequency processing circuit (1a, 1b) is a frequency conversion stage using a bipolar transistor as an active element for frequency conversion.

4.    An intermodulation suppressing circuit according to claim 3 wherein said shunting circuit (10) is composed of a series resonance connection of an inductance and a capacitance.

0201986

5.     An intermodulation suppressing circuit according to claim 1 wherein said frequency processing circuit (1a, 1b) is a frequency conversion circuit using a field effect transistor as an active element for frequency conversion.

6.     An intermodulation suppressing circuit according to claim 5 wherein said shunting circuit (10) is composed of a series resonance connection of an inductance and a capacitance.

7.     An intermodulation suppressing circuit according to claim 1 wherein said frequency processing circuit (1a, 1b) is a balance type frequency conversion circuit using a pair of diodes in parallel.

8.     An intermodulation suppressing circuit according to claim 7  wherein said shunting circuit (10) is composed of a series resonance connection of an inductance and a capacitance.

9.     An intermodulation suppressing circuit according to claim 1 wherein said frequency processing circuit (1a, 1b) is a high-frequency amplification stage of said radio receiver.

10.     An intermodulation suppressing circuit according to claim 9 wherein said shunting circuit (10) is composed of a series resonance connection of an inductance and a capacitance.

FIG.1(A)

FIG.1(B)

# FIG_2

FIG_3(A)

FIG_3(B)

FIG_3(C)

# F I G _ 4 (A)

# F I G _ 4 (B)

FIG_5

0201986